# EUROPEAN PATENT APPLICATION

(11) **EP 4 354 742 A1**
(43) Date of publication of application: **17.04.2024**
(21) Application number: 22201014.2
(22) Date of filing: 12.10.2022
(51) Int. Cl.: H04B 1/525, H03F 1/32

(54) **FLEXIBLE RECEPTION**

(71) Applicant: Nokia Technologies Oy, 02610 Espoo (FI)
(72) Inventor: NIELSEN, Kim, Storvorde (DK)
(74) Representative: Nokia EPO representatives

(57) **Abstract**

An apparatus comprising:
a first reception path comprising a first low noise amplifier;
a first feedback path comprising a second low noise amplifier;
first downstream receiver circuitry;
a switching arrangement configured to, in a first state, couple the first reception path to the first downstream receiver circuitry and configured to, in a second state, couple the first feedback path to the first downstream receiver circuitry; and a controller configured to place the switching arrangement in the first state during a reception time slot and in the second state during a transmission time slot.

## Description

### TECHNOLOGICAL FIELD

Examples of the disclosure relate to an apparatus, system, method, computer program that provide flexible reception.

### BACKGROUND

A signal received via an antenna port comprises a target spectrum (or bandwidth) that comprises modulated information and a non-target spectrum (or bandwidth) that does not comprise modulated information.

In non-contiguous carrier aggregation, a signal received via an antenna port comprises two or more discrete target spectrums (or bandwidths) that comprise modulated information and that are separated by a non-target spectrum (or bandwidth) that does not comprise modulated information.

### BRIEF SUMMARY

The inventors have realized that it can be desirable to separately process multiple target spectrums (or bandwidths) received via a single antenna port using respective multiple downstream receiver circuitry.

The separate processing of multiple bandwidths received via a single antenna port can provide carrier aggregation where parallel processing for different carriers, avoids intercarrier interference.

The separate processing of multiple bandwidths received via a single antenna port can provide for dynamic bandwidth extension using predefined bandwidths. The bandwidth extension enables the use of bandwidths intermediate the existing predefined bandwidths. The extended bandwidth can be extended in an analogue fashion without quantization. This enables the efficient utilization of licensed spectrum that is not aligned with existing bandwidths.

According to various, but not necessarily all, examples there is provided an apparatus comprising:
a first reception path comprising a first low noise amplifier;
a first feedback path comprising a second low noise amplifier;
first downstream receiver circuitry;
a switching arrangement configured to, in a first state, couple the first reception path to the first downstream receiver circuitry and configured to, in a second state, couple the first feedback path to the first downstream receiver circuitry; and a controller configured to place the switching arrangement in the first state during a reception time slot and in the second state during a transmission time slot.

In some, but not necessarily all examples, the first feedback path is configured to receive transmission signals on a transmission path, the apparatus comprising means for processing received transmission signals received via the first feedback path and first downstream receiver circuitry, during a transmission time slot, to control envelope tracking and digital pre-distortion of transmission signals transmitted via the transmission path.

In some, but not necessarily all examples, the apparatus comprises a second downstream receiver circuitry;
the apparatus being:
configured to split the first reception path into at least a first part and a second part; configured to couple the first downstream receiver circuitry, during a reception time slot, to a first part of the first reception path;
configured to couple the second downstream receiver circuitry, during the reception time slot, to a second part of the first reception path;
configured to couple the first downstream receiver circuitry, during the transmission time slot, to the first feedback path.

In some, but not necessarily all examples, the apparatus comprises multiple reception paths including the first reception path and a second reception path; wherein the switch arrangement is configured to couple the first downstream receiver circuitry, during a reception time slot, to the any one of the multiple reception paths and configured to couple the first downstream receiver circuitry, during a transmission time slot, to the first feedback path.

In some, but not necessarily all examples, the switch arrangement is configured to have:
a state that couples the first reception path but not the first feedback path to the downstream receiver circuitry; and
a state that couples the first feedback path but not the first reception path to the downstream receiver circuitry.

In some, but not necessarily all examples, the switching arrangement comprises:
a first switching circuitry configured to have a first switching state that enables coupling of the first reception path to the first downstream receiver circuitry and a second switching state that disables coupling of the first reception path to the first downstream receiver circuitry;
a second switching circuitry configured to have a first switching state that enables coupling of the first feedback path to the first downstream receiver circuitry and a second switching state that disables coupling of the first feedback path to the first downstream receiver circuitry,
wherein a switching state that couples the first reception path but not the first feedback path to the first downstream receiver circuitry comprises a first switching state of the first switching circuitry and a second switching state of the second switching circuitry; and
a switching state that couples the first feedback path but not the first reception path to the first downstream receiver circuitry comprises a second switching state of the first switching circuitry and a first switching state of the second switching circuitry.

In some, but not necessarily all examples, the switching arrangement is configured to enable coupling of the first reception path to first downstream receiver circuitry by selectively coupling a first upstream node coupled to the first reception path and a first downstream node coupled to the first downstream receiver circuitry and disable coupling of the first reception path to the first downstream receiver circuitry by selectively decoupling the first upstream node and the first downstream node and terminating the first upstream node to ground and the first downstream node to ground.

In some, but not necessarily all examples, the switching arrangement is configured to enable coupling of the first feedback path to first downstream receiver circuitry by selectively coupling an upstream node coupled to the first feedback path and a downstream node coupled to the first downstream receiver circuitry and disable coupling of the first feedback path to the first downstream receiver circuitry by selectively decoupling the upstream node and the downstream node and terminating the upstream node to ground and the downstream node to ground.

In some, but not necessarily all examples, the apparatus is configured to separately control frequency offsets applied to the first reception path and the first feedback path before processing via the first downstream receiver circuitry.

In some, but not necessarily all examples, the controller is configured to place the switching arrangement in the first state to support reception of a first bandwidth, wherein the switching arrangement is configured in the first state to enable processing of the received first bandwidth as a plurality of overlapping bandwidths wherein one of the plurality of overlapping bandwidths is processed via the first downstream receiver circuitry and another one of the plurality of overlapping bandwidths is processed via a second downstream receiver circuitry, and/or wherein the controller is configured to place the switching arrangement in the first state to support carrier aggregation, wherein the switching arrangement is configured in the first state to enable processing of a first component carrier by the first downstream receiver circuitry and processing of a second component carrier by a second downstream receiver circuitry.

In some, but not necessarily all examples, the controller is configured to determine a state of the switching arrangement, during a reception time slot, in dependence upon any one or more of:
network configuration as regards non-contiguous intra-band carrier aggregation;
network configured irregular bandwidth;
availability of downstream receiver circuitry;
interference, if any, in frequencies adjacent the received first bandwidth.

In some, but not necessarily all examples, the controller is configured to: update capability information provided to a network in dependence upon availability of downstream receiver circuitry.

According to various, but not necessarily all, examples there is provided a method comprising:
during a transmission time slot, couple a first feedback path to a first downstream receiver circuitry; and
during a reception time slot, couple a first reception path to the first downstream receiver circuitry.

According to various, but not necessarily all, examples there is provided a computer program comprising instructions that when run by one or more processors causes a switching arrangement to:
during a transmission time slot, couple a first feedback path to a first downstream receiver circuitry; and
during a reception time slot, couple a first reception path to the first downstream receiver circuitry.

According to various, but not necessarily all, examples user equipment comprises the apparatus.

According to various, but not necessarily all, examples there is provided examples as claimed in the appended claims.

While the above examples of the disclosure and optional features are described separately, it is to be understood that their provision in all possible combinations and permutations is contained within the disclosure. It is to be understood that various examples of the disclosure can comprise any or all of the features described in respect of other examples of the disclosure, and vice versa. Also, it is to be appreciated that any one or more or all of the features, in any combination, may be implemented by/comprised in/performable by an apparatus, a method, and/or computer program instructions as desired, and as appropriate.

### BRIEF DESCRIPTION

Some examples will now be described with reference to the accompanying drawings in which:
FIG. 1A shows an example of the subject matter described herein;
FIG. 1B shows an example of the subject matter described herein;
FIG. 2A shows another example of the subject matter described herein;
FIG. 2B shows another example of the subject matter described herein;
FIG. 3A shows another example of the subject matter described herein;
FIG. 3B shows another example of the subject matter described herein;
FIG. 4 shows another example of the subject matter described herein;
FIG. 5 shows another example of the subject matter described herein;
FIG. 6 shows another example of the subject matter described herein;
FIG. 7 shows another example of the subject matter described herein;
FIG. 8 shows another example of the subject matter described herein;
FIG. 9 shows another example of the subject matter described herein;
FIG. 10 shows another example of the subject matter described herein;
FIG. 11 shows another example of the subject matter described herein;
FIG. 12 shows another example of the subject matter described herein;
FIG. 13 shows another example of the subject matter described herein.

The figures are not necessarily to scale. Certain features and views of the figures can be shown schematically or exaggerated in scale in the interest of clarity and conciseness. For example, the dimensions of some elements in the figures can be exaggerated relative to other elements to aid explication. Similar reference numerals are used in the figures to designate similar features. For clarity, all reference numerals are not necessarily displayed in all figures.

In the following description a class (or set) can be referenced using a reference number without a subscript index (e.g., 10) and a specific instance of the class (member of the set) can be referenced using the reference number with a numerical type subscript index (e.g., 10_1) and a non-specific instance of the class (member of the set) can be referenced using the reference number with a variable type subscript index (e.g., 10_i).

### DETAILED DESCRIPTION

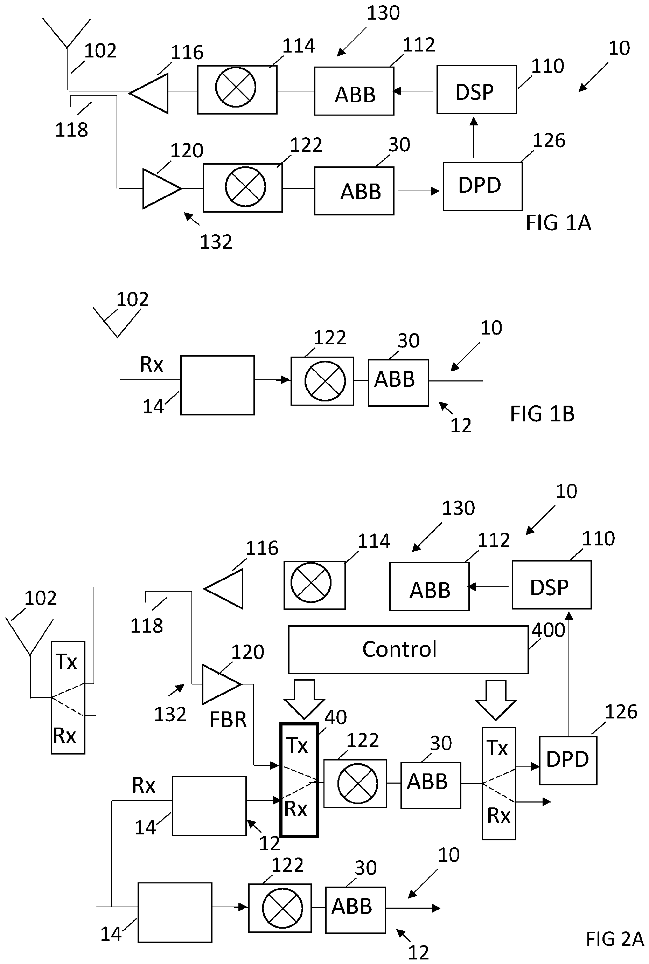

FIG 1A illustrates an example of an apparatus 10 configured for envelope tracking and digital pre-distortion of a transmitted signal.

The apparatus 10 comprises at least one transmission path 130. The illustrated transmission path 130 comprises digital signal processing (DSP) circuitry 110 for producing a digital signal, analogue baseband (ABB) circuitry 112 include digital to analogue conversion for converting the digital signal from the digital domain to the analogue domain, frequency conversion circuitry 114 (for example a mixer) for up-converting the analogue signal to radio frequencies, a power amplifier (PA) 116 for amplifying the radio frequency signal and an antenna 102 for transmitting the amplified radio frequency signal.

The apparatus 10 also comprises a feedback path 132 that forms a feedback reception loop (FBR) for controlling the transmitted, amplified radio frequency signal.

The feedback path 132 comprises a detector 118, for example a directional coupler, associated with the transmission path 130, for receiving an analogue signal dependent upon the amplified radio frequency signal produced by the power amplifier 116, a linear amplifier 120, frequency conversion circuitry 122 (for example a mixer) for down-converting the analogue received signal from radio frequencies, analogue baseband circuitry 30 including an analogue filter for performing filtration before analogue to digital conversion that converts the received analogue signal from the analogue domain to the digital domain, digital pre-distortion (DPD) circuitry for processing the digital received signal (received from the transmission path 130) and controlling at least the digital signal processing circuitry 110 in the transmission path 130.

Amplitudes at higher transmit power levels can undergo non-linear distortion.
The digital pre-distortion (DPD) circuitry 126 applies inverse distortion to the signal input to the power amplifier 116 that cancels distortion generated by the power amplifier 116. The DPD algorithm must know a delay of the transmitted signal to apply the digital predistortion with the correct timing. The DPD algorithm must also measure the generated distortion. The DPD algorithm therefore uses the feedback path 132 to receive the transmitted signal for further processing including down-conversion 122. The feedback path 132 leads into a down-converter 122 that is followed by envelope tracking and digital predistortion management and processing that is then applied on the transmit signal via digital signal processing and, if necessary, at the bias- or supply-voltage of the power amplifier 114.

The feedback path 132 converts the power amplifier output from radio frequency to digital and the digital pre-distortion (DPD) circuitry 126 determines the power amplifier transfer function. It is not necessary to separate the carriers or demodulate the digital data. Power amplifier nonlinearity produces odd order intermodulation products in the adjacent and alternate channels. Third-order intermodulation products appear within a range of three times the bandwidth of the desired channel and fifth-order products appear within a range of five times the bandwidth and seventh-order products within seven times the bandwidth. Therefore, the digital pre-distortion (DPD) circuitry 126 typically acquires an odd multiple of the transmit bandwidth equivalent to the order of the intermodulation products being linearized.

The apparatus 10 comprises at least one reception path 112, for example as illustrated in FIG 1B. The illustrated reception path 112 comprises: an antenna 102 for receiving a radio frequency signal; a low-noise amplifier 14 for amplifying the radio frequency signal; frequency conversion circuitry 122 (for example a mixer) for down-converting the radio frequency signal; and analogue baseband (ABB) circuitry 30 include digital to analogue conversion for converting the down-converted signal from the analogue domain to the digital domain to provide a digital signal for further processing.

When the apparatus 10 is configured to operate in time division duplex (TDD) mode, it has time slots dedicated to transmission and different time slots dedicated to reception. Where the apparatus 10 is a terminal apparatus, for example, a user equipment, the network controls, via signaling, which time slots are for transmission (e.g. uplink) and which slots are used for reception (e.g. downlink)

Previously, the feedback path 132 and its components such as the analogue baseband circuitry 30 have only been used as a feedback path for transmission support. As such, the feedback path 132 and its components such as the analogue baseband circuitry 30 have previously only been used during transmission slots since the feedback path 132 has previously been dedicated to transmission support for improved linearity and power consumption benefits. The inventors have realized that the feedback path 132 and at least some of its components such as the analogue baseband circuitry 30 can be re-used and re-purposed during reception time slots in a TDD mode.

The inventors have realized that at least the analogue baseband circuitry 30 of the feedback path 132 can be re-used during reception time slots in a TDD mode, and re-purposed to support an 'expansion' of receiver bandwidth. This can, for example, be realized as support for irregular bandwidths and/or support for additional component carrier support for carrier aggregation. In at least some examples, the additional component carrier can be tightly filtered to avoid interference outside the bandwidth of the additional component carrier. This can, for example, be used to support continuous intra-band carrier aggregation and/or non-contiguous intra-band carrier aggregation in TDD bands.
The ability to support, flexibly, an additional component carrier can allow the apparatus 10 to maintain support for a declaration, to the network, of its capability to support a specific number of component carriers, without reporting a reduced level of support when circumstances would otherwise require it to do so.

The following description relates to a time division duplex mode of operation in which the apparatus 10 transmits in transmission time slots and receives in different reception time slots. The apparatus 10 is not transmitting and receiving in the same time slots.

The following FIGs illustrate examples of an apparatus 10 comprising:
a first reception path 12 comprising a first low noise amplifier 14;
a first feedback path 132 comprising a second low noise amplifier 120;
first downstream receiver circuitry 30;
a switching arrangement 40 configured to, in a first state 41, couple the first reception path 12 to the first downstream receiver circuitry 30 and configured to, in a second state 42, couple the first feedback path 132 to the first downstream receiver circuitry 30; and
a controller 400 configured to place the switching arrangement 40 in the first state 41 during a reception time slot and in the second state 42 during a transmission time slot.

The terms "downstream" and "upstream" are commonly used terms in this field to describe the ordered position of one component relative to another component in a reception path. A reception path has an inherent direction- the direction of the received signal. The signal arrives at an upstream location of the reception path before it travels to a downstream location in the reception path. This time sequence creates an inherent order to the components within the reception path. Thus one component can be described as upstream or downstream of another component dependent upon its relative position within the reception path.

The transmission time slot is a time slot used by the apparatus 10 for transmission. The reception time slot is a time slot used by the apparatus 10 for reception.

The transmission time slot is a time slot used by the apparatus 10 for wireless transmission of a signal to another apparatus and the reception time slot is a time slot used by the apparatus 10 for wireless reception of a signal from another apparatus.

Where the apparatus 10 is configured as a terminal node, for example where the apparatus is configured as user equipment the transmission time slot is a time slot used by the apparatus 10 for uplink transmission and the reception time slot is a time slot used by the apparatus 10 for downlink reception
FIG 2A illustrates an example of an apparatus 10 that combines the features of FIGs 1A and 1B. These features will not be re-described.

The apparatus 10 additionally comprises an analogue switching arrangement 40 and a controller 400. The switching arrangement 40 is configured to, in a first state 41, couple the first reception path 12 to the first downstream receiver circuitry 30 and configured to, in a second state 42, couple the first feedback path 132 to the first downstream receiver circuitry 30. The controller 400 is configured to place the switching arrangement 40 in the first state 41 during a reception time slot and in the second state 42 during a transmission time slot.

The apparatus 10 additionally illustrates a 'switch' after the downstream receiver circuitry 30. However, this is a selection implemented in the digital domain, optionally, under the control of the controller 400.

It should be appreciated that the original reception path 12 has now been split, during a reception time slot into two parallel reception paths 12 which can be processed separately. This separate processing allows for separate analogue filtration (optionally using pre-set standard filters) which enables the splitting of an irregular bandwidth into overlapping regular bandwidths that are separately processed. This separate processing allows for precise filtering of component carriers separately thus removing noise in the frequency spectrum between the component carriers.

Thus in at least some examples filters which are specifically designed for irregular bandwidths do not need to be designed, bought and implemented in devices. Off-the-shelf regular filters can be used, thereby enabling use of regular filters as irregular bandwidth filters.

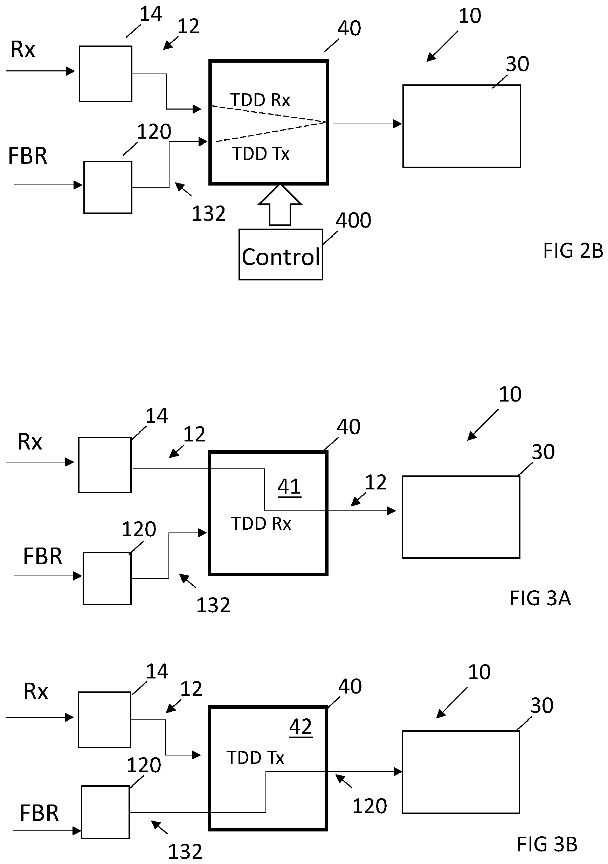

FIG 2B illustrates simplified example of the apparatus 10. The apparatus 10 comprises a first reception path 12, a first feedback path 132, first downstream receiver circuitry 30, a switching arrangement 40 and a controller 400.

The first reception path 12 comprises a first low noise amplifier 14.

The first feedback path 132 comprises a second low noise amplifier 120. The feedback path 132 is associated with the transmission path 130 as described with reference to FIG 1A and 2A and can be used for controlling digital pre-distortion during a transmission time slot.

In at least some examples, the first downstream receiver circuitry 30 is configured to process a received signal, received via the antenna 102 and feedback path 132 during a reception time slot and process a received signal, received via feedback path 132 during a transmission time slot. The first downstream receiver circuitry 30 comprises analogue baseband circuitry that includes analogue to digital conversion circuitry for converting a received analogue signal from the analogue domain to the digital domain. This analogue baseband circuitry can be re-used, for different applications, in the transmission time slots and the reception time slots.

The switching arrangement 40 is configured to, in a first state 41, couple the first reception path 12 to the first downstream receiver circuitry 30 and configured to, in a second state 42, couple the first feedback path 132 to the first downstream receiver circuitry 30.

The controller 400 is configured to place the switching arrangement 40 in the first state 41 during a reception time slot and in the second state 42 during a transmission time slot.

In this example, the switch arrangement 40 is configured to have: a state 41 that couples the first reception path 12 but not the first feedback path 132 to the downstream receiver circuitry 30; a state 42 that couples the first feedback path 132 but not the first reception path 12 to the downstream receiver circuitry 30. The controller 400 is configured to place the switching arrangement 40 in the first state 41 (not the second state 42) during a reception time slot and in the second state 42 (not the first state 41) during a transmission time slot. The controller 400 can be configured to prevent the switching arrangement 40 being in the second state 42 during a reception time slot and/or prevent the switching arrangement 40 being in the first state 41 during a transmission time slot.

FIG 3A illustrates the apparatus 10 when the switching arrangement 40 is in the first state 41 during a reception time slot. FIG 3B illustrates the apparatus 10 when the switching arrangement 40 is in the second state 42 during a transmission time slot.

The switching arrangement 40 couples the first downstream receiver circuitry 30, during a reception time slot, to the first reception path 12 (FIG 3A) and couples the first downstream receiver circuitry 30, during a transmission time slot, to the first feedback path 132 (FIG 3B).

The controller 400 can, for example, control the switching arrangement 40 to exit or enter the first state 41. The controller 400 can, for example, control the switching arrangement 40 to exit or enter the second state 42. In some examples, the controller 400 can, for example, control the switching arrangement 40 to toggle between the first state 41 and the second state 42.

As previously described with reference to FIG 1A, the first feedback path 132 is configured to receive transmission signals on a transmission path during a transmission time slot. The apparatus 10 is configured to process the received transmission signals received via the first feedback path 132 and first downstream receiver circuitry 30, during a transmission time slot, to control envelope tracking and digital pre-distortion of transmission signals transmitted via the transmission path.

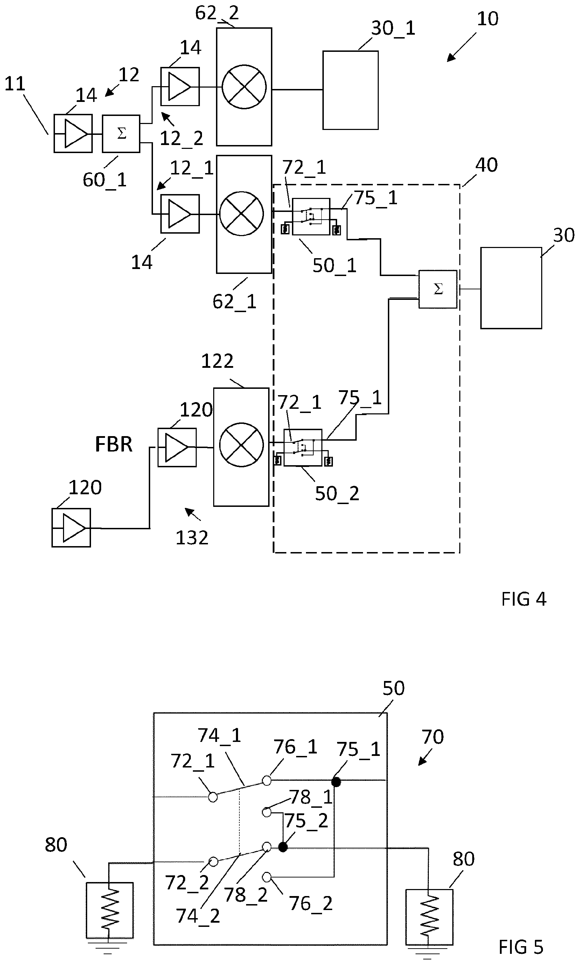

FIG 4 illustrates an example of the apparatus 10. The apparatus 10 additionally comprises downstream receiver circuitry 30_1 for at least analogue filtering distinct from analogue filtering of the downstream receiver circuitry 30.

The apparatus 10 is configured to split the first reception path 12 into at least a first part 12_1 and a second part 12_2. The apparatus 10 is configured to couple the first downstream receiver circuitry 30, during a reception time slot, to a first part 12_1 of the first reception path 12; configured to couple the second downstream receiver circuitry 30_1, during the reception time slot, to a second part 12_2 of the first reception path 12; and configured to couple the first downstream receiver circuitry 30, during the transmission time slot, to the first feedback path 132.

The apparatus 10 is configured to separately control frequency offsets applied to the first and second parts 12_1, 12_2 of the first reception path 12 and the first feedback path 132 before processing via the first downstream receiver circuitry 30.

The received signal 11 is split by splitter 60_1 into two along a path 12_2 via a low-noise amplifier 14 and a frequency shift circuitry 62_2 (mixer) to be processed at downstream receiver circuitry 30_1, and along a path 12_1 via a low-noise amplifier 14 and a frequency shift circuitry 62_1 (mixer) to the switching arrangement 40 which controls whether or not the switched signal is processed at downstream receiver circuitry 30.

First frequency shift circuitry 62_2 (a mixer) introduces a first frequency shift to the received signal 11 in the path 12_2.

Second frequency shift circuitry 62_1 (a mixer) introduces a second frequency shift to the received signal 11 in the path 12_1.

The switching arrangement 40 comprises:
a first switching circuitry 50_1 configured to have a first switching state that enables coupling of the first reception path 12 to the downstream receiver circuitry 30 and a second switching state that disables coupling of the first reception path 12 to the downstream receiver circuitry 30; and
a second switching circuitry 50_2 configured to have a first switching state that enables coupling of the first feedback path 132 to the downstream receiver circuitry 30 and a second switching state that disables coupling of the first feedback path 132 to the downstream receiver circuitry 30.

A switching state that couples the first reception path 12 but not the first feedback path 132 to the downstream receiver circuitry 30 comprises a first switching state of the first switching circuitry 50_1 and a second switching state of the second switching circuitry 50_2.

A switching state that couples the first feedback path 132 but not the first reception path 12 to the downstream receiver circuitry 30 comprises a second switching state of the first switching circuitry 50_1 and a first switching state of the second switching circuitry 50_2.

The downstream receiver circuitry 30 can therefore be used by either the first reception path 12 or the first feedback path 132.

The switching arrangement 40 is configured, via switch 50_1, to enable coupling of the first reception path 12 to downstream receiver circuitry 30 by selectively coupling a first upstream node 72_1 coupled to the first reception path 12 and a first downstream node 75_1 coupled to the downstream receiver circuitry 30 and disable coupling of the first reception path 12 to the downstream receiver circuitry 30 by selectively decoupling the first upstream node 72_1 and the first downstream node 75_1 and terminating the first upstream node 72_1 to ground and the first downstream node 75_1 to ground.

The switching arrangement 40 is configured, via switch 50_2, to enable coupling of the first feedback path 132 to downstream receiver circuitry 30 by selectively coupling a first upstream node 72_1 coupled to the first feedback path 132 and a first downstream node 75_1 coupled to the downstream receiver circuitry 30 and disable coupling of the first feedback path 132 to the downstream receiver circuitry 30 by selectively decoupling the first upstream node 72_1 and the first downstream node 75_1 and terminating the first upstream node 72_1 to ground and the first downstream node 75_1 to ground.

An example of a switch 50 that can be used as a switch 50_1 and/or switch 50_2 of the switching arrangement 40 is illustrated in FIG 5. Other examples of switches can be used.

The switch 50 illustrated in FIG 5 is a dual pole dual throw (DPDT) switch.

The switch 50 has a first switching state (illustrated) that enables coupling of an upstream reception path node 72_1 to a downstream receiver circuitry node 75_1 and a second switching state (not illustrated) that disables coupling of the upstream reception path node 72_1 to the downstream receiver circuitry node 75_1. The upstream reception path node 72_1 is an upstream node coupled to a reception path. The downstream receiver circuitry node 75_1 is a downstream node coupled to the downstream receiver circuitry 30.

The switching circuitry 50 also comprises a downstream ground terminating node 75_2 that is connected to ground 80 and an upstream ground terminating node 72_2 that is connected to ground 80.

The first 'closed' switching state (illustrated) interconnects:
(i) the upstream reception path node 72_1 and the downstream receiver circuitry node 75_1,
(ii) the downstream ground terminating node 75_2 and the upstream ground terminating node 72_2.

The second 'open' switching state (not illustrated) couples:
(i) the upstream reception path node 72_1 and the downstream ground terminating node 75_2,
(ii) downstream receiver circuitry node 75_1 and the upstream ground terminating node 72_2.

The selector 74_1 selectively couples the upstream reception path node 72_1 to either the downstream receiver circuitry node 75_1 or the downstream ground terminating node 75_2.

The selector 74_2 selectively couples the upstream ground terminating node 72_2 to either the downstream ground terminating node 75_2 or the downstream receiver circuitry node 75_1.

The selectors, 74_1 and 74_2, are controlled to change position together.

In this example, but not necessarily all examples, the switching circuitry 50 is a dual pole dual throw (DPDT) switch (also known as a double pole double throw switch). A first pole is the upstream reception path node 72_1. It has two throws, nodes 76_1 and 78_1. The node 76_1 is coupled to downstream receiver circuitry node 75_1. The node 78_1 is coupled to downstream ground terminating node 75_2. A second pole is the upstream ground terminating node 72_2. It has two throws, nodes 76_2 and 78_2. The node 78_2 is coupled to downstream ground terminating node 75_2. The node 76_2 is coupled to downstream receiver circuitry node 75_1.

A DPDT switch can be replaced by a combination of two single pole double throw (SPDT) switches or other switching arrangements.

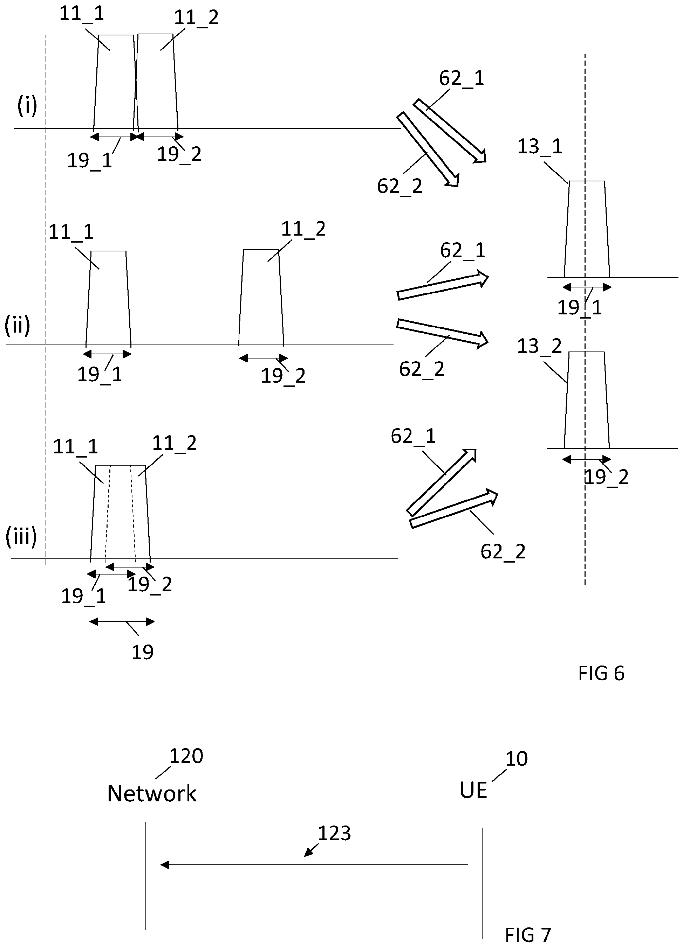

FIG 6 illustrates parallel down-conversion of separate component carriers (CC) from a single band and parallel down-conversion of overlapping parts of a spectrum 90.

In FIG 6(i) and 6(ii), a received signal 11 received during a reception slot is received as two different received signals 11_1, 11_2 (component carriers). In this example there is no overlapping data between component carriers. The received signal 11 has a total bandwidth that has been split by the network into sub-bands 19_1, 19_2 of component carriers 11_1, 11_2. The apparatus 10 can be configured to apply frequency-shifting to the respective sub-bandwidths 19_1, 19_2 (component carriers 11_1, 11_2) to create frequency shifted component carriers 13_1, 13_2. The apparatus 10 can then perform separate demodulation for the frequency shifted component carriers 13_1, 13_2.

FIG 6(i) illustrates intraband contiguous carrier aggregation. The sub-bands 19_1, 19_2 are initially immediately adjacent without a frequency gap.

The sub-bands 19_1, 19_2 have upper and lower limits. The sub-bands are within the upper and lower limits of the band.

For contiguous intra-band carrier aggregation, where there is little or no interference in frequencies below the lower frequency component carrier 11_1 or above the higher frequency component carrier 11_2, then a wideband filter can be used with a single downstream receiver circuitry 30, to receive and demodulate the component carriers 11_1, 11_2 simultaneously. Where there is interference above a threshold in these regions, then a narrow band filter can be used with different, distinct, downstream receiver circuitry 30, 30_1 to separately receive and demodulate the component carriers.

FIG 6(ii) illustrates intraband non-contiguous carrier aggregation. The sub-bands 19_1, 19_2 are initially separated by a frequency gap.

For non-contiguous intra-band carrier aggregation, where there is little or no interference in the frequency gap between different component carriers 11_1, 11_2, then a wideband filter can be used with a single downstream receiver circuitry 30, to receive and demodulate the component carriers 11_1, 11_2 simultaneously. Where there is interference above a threshold in the frequency gap between different component carriers 11_1, 11_2, then a narrow band filter can be used with different, distinct, downstream receiver circuitry 30, 30_1 to separately receive and demodulate the component carriers.

In FIG 6(iii) a received signal 11 received during a reception slot is received as a single signal. The received signal 11 has a total received bandwidth 19 that has been determined by the network.

The received downlink signal 11 having a received bandwidth 19 can be logically represented as two overlapping signals: first signal 11_1 having bandwidth 19_1 and second signal 11_2 having bandwidth 19_2. The two overlapping signals 11_1, 11_2 can be separately processed by the apparatus 10. In this example, a different frequency shift is applied to the two overlapping signals 11_1, 11_2 to produce frequency-shifted signals 13_1, 13_2 that can be separately processed in separate downstream receiver circuitry. 'Overlapping' means that a bandwidth overlaps with at least one other bandwidth. If there are three bandwidths (A, B, C) then A overlaps B and B overlaps C but A does not necessarily overlap C. Thus, an irregular channel bandwidth 19 that does not match any preset regular filter bandwidth can be converted into multiple overlapping signals 11_1, 11_2 that have reduced bandwidths 19_1, 19_2 matching preset regular filter bandwidths. In at least some examples, the preset regular filter bandwidths e.g., 19_1, 19_2 are specified by a telecommunications standard with which the apparatus 10 complies.

In at least some examples, the apparatus 10 is configured to control relative frequency offsets applied to the plurality of overlapping bandwidths 19_1, 19_2 before processing via one of the plurality of the multiple downstream receiver circuitry. Each of the multiple downstream receiver circuitry 30_1, 30 is configured for separate demodulation of a respective overlapping bandwidth 19_1, 19_2. The apparatus 10 is configured to manage data overlap in the respective overlapping bandwidths 19_1, 19_2. The apparatus 10 is therefore able to split an irregular bandwidth 19 into sub-bandwidths 19_1, 19_2, apply frequency-shifting to the sub-bandwidths 19_1, 19_2, perform separate demodulation for the frequency shifted sub-bandwidths and manage overlapping data.

In at least some examples, the apparatus 10 is configured to determine how to enable processing of the received bandwidth 19 as the plurality of bandwidths 19_1, 19_2 which may be contiguous, non-contiguous or overlapping.

The bandwidth 19_1 and the bandwidth 19_2 of the signals 11_1, 11_2 can be selected to match existing available preset filters.

The frequency shift applied between the signals 11_1, 11_2 can be selected so that the bandwidth 19_1 and bandwidth 19_2 cover the total bandwidth of the received signal 11.

The bandwidth 19_1 can fit within a regular bandwidth of a predetermined analogue filter. The bandwidth 19_2 can fit within a regular bandwidth of a predetermined analogue filter 4_2. In some but not necessarily all examples, the bandwidth 19_1 and the bandwidth 19_2 are the same bandwidth.

From the foregoing, it will be understood that in at least some examples the controller 400 is configured to place the switching arrangement 40 in the first state 41 to support carrier aggregation, wherein the switching arrangement 40 is configured in the first state to enable processing of a first component carrier 11_1 by the first downstream receiver circuit 30_1 and processing of a second component carrier 11_2 by a second downstream receiver circuitry 30.

From the foregoing, it will be understood that in at least some examples the controller 400 is configured to place the switching arrangement 40 in the first state 41 to support reception of a first bandwidth, wherein the switching arrangement 40 is configured in the first state 41 to enable processing of the received first bandwidth as a plurality of overlapping bandwidths 19_1, 19_2 wherein each of the plurality of overlapping bandwidths is processed via one of a plurality of the multiple downstream receiver circuitry 30_1, 30.

In some examples, the controller 400 is configured to determine a state of the switching arrangement 40, during a reception time slot, in dependence upon any one or more of:
network requirements as regards intraband carrier aggregation;
network configured irregular bandwidth;
availability of downstream receiver circuitry;
interference, if any, in frequencies adjacent the received first bandwidth.

As illustrated in FIG 7 in at least some examples the apparatus 10 is configured to send a communication 123 informing the network 120 of an update to its reported capability. In this example, the apparatus 10 is user equipment (UE) of a 3GPP New Radio and the network node 120 is a base station (e.g., gNB of 3GPP New Radio). The capability of an apparatus 10 for carrier aggregation can be signaled to a network node 120. The capability of an apparatus 10 for carrier aggregation will change as the apparatus uses available downstream receiver circuitry 30. For example, the apparatus 10 can decide to configure each one of the paths 12, 132 to use a respective single downstream receiver circuitry 30, 30_1. The apparatus 10 can alternatively decide to configure one of the paths 12 to use two downstream receiver circuitry 30, 30_1 in parallel. In response to the apparatus 10 deciding to change how it uses downstream receiver circuitry 30 then, the apparatus 10 can communicate 123 this change to the network 120.

The controller 400 is configured to: update capability information provided to a network 120 in dependence upon availability of downstream receiver circuitry 30.

By making the downstream receiver circuitry 30 used during transmission slots available for use, for example carrier aggregation, during a reception slot, it is possible to avoid reporting of reduced carrier aggregation capability to the network 120 when the apparatus 10 is connected through irregular bandwidth and/or non-contiguous intra-band carrier aggregation in need of improved interference reduction.

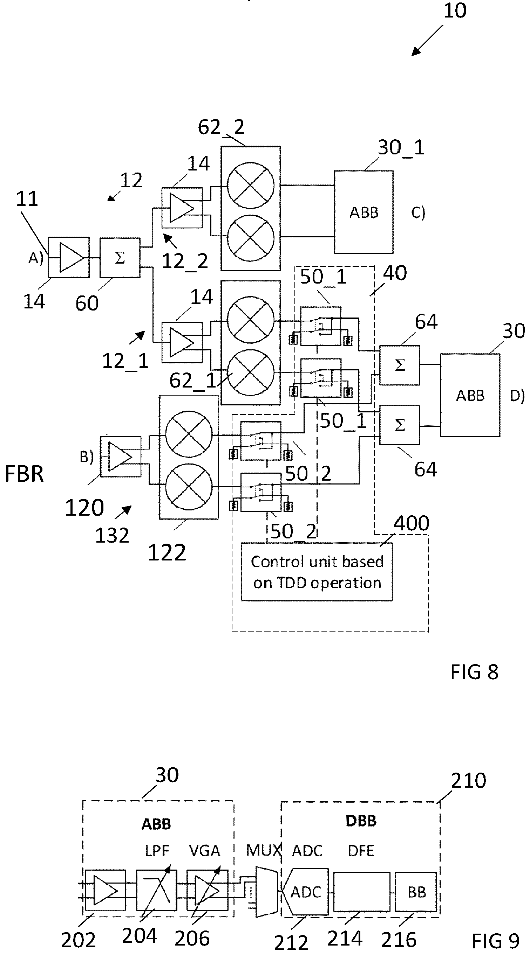

FIG 8 illustrates an example of the apparatus 10 as previously described with reference to FIG 4. However, in this example, the apparatus 10 is configured for frequency division of the reception path 12 and of the feedback path 132. Frequency division of a reception path 12 and/or feedback path 132 can also be implemented in any of the previous examples.

The part 12_1 of reception path 12 is split into multiple frequency separated paths that are switched separately.

The feedback path 132 is split into multiple frequency separated paths that are switched separately.

FIG 9 illustrates an example of downstream receiver circuitry 30. The downstream receiver circuitry 30 is analogue baseband (ABB) circuitry. The downstream receiver circuitry 30 prepares the received signals for analogue to digital conversion and demodulation by digital baseband (DBB) circuitry 210.

The downstream receiver circuitry 30 comprises, in this example: an operational amplifier 202; an analogue lowpass filter (LPF) 204; a variable gain amplifier (VGA) 206 for level control; a multiplexer (MUX); an analogue to digital converter (ADC) 212; a digital channel filter (DFE) 214; and baseband (BB) circuitry interface 216.

The operational amplifier 202 translates the impedance from radio frequency to baseband (BB) favorable levels.

The analogue filter 204 has a preset regular filter bandwidth e.g., bandwidth 19_1, 19_2 rather than irregular bandwidth 19. A pre-set regular filter bandwidth e.g., 19_1, 19_2 is specified by a telecommunications standard with which the apparatus 10 complies. In this example, the analogue filter 204 is adjustable to have any of the preset, standardized regular filter bandwidths.

The variable gain amplifier 206 is for level control. The analogue to digital converter (ADC) converts from the analogue domain to the digital domain. The digital channel filter 214 provides for noise and adjacent channel suppression, and the baseband circuitry interface 216 is the digital interface that transfers the signal from the transceiver chip to the baseband modem processors which can, for example, be in different integrated circuits.

The downstream receiver circuitry 30 comprises the operational amplifier 202, the analogue filter 204 and the variable gain amplifier 206 for level control.

The digital baseband circuitry 210 comprises the analogue to digital converter (ADC) 212, the digital channel filter 214 and the baseband circuitry interface 216 to baseband circuitry for demodulating the received signal.

The filter 204 can be implemented as a low-pass filter that creates a pass band at DC or as a passband, for example, a notch-type filter that passes frequencies in one passband but does not pass frequencies above or below that pass band.

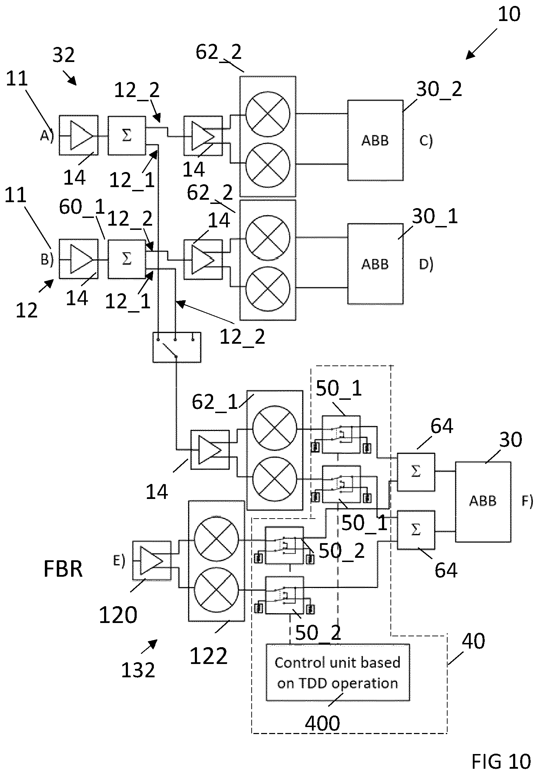

FIG 10 illustrates an example of the apparatus 10. The apparatus 10 additionally comprises downstream receiver circuitry 30_2 for at least analogue filtering distinct from analogue filtering of the downstream receiver circuitry 30_1 and downstream receiver circuitry 30.

The apparatus 10 is configured to couple the first downstream receiver circuitry 30, during the transmission time slot, to the first feedback path 132.

The apparatus 10 is configured to split a first reception path 12 into at least a first part 12_1 and a second part 12_2.

The apparatus 10 is configured to split a second reception path 32 into at least a first part 12_1 and a second part 12_2.

The apparatus 10 is configured to couple the downstream receiver circuitry 30_1, during the reception time slot, to a second part 12_2 of the first reception path 12.

The apparatus 10 is configured to couple the downstream receiver circuitry 30_2, during the reception time slot, to a second part 12_2 of the second reception path 32.

The apparatus 10 is configured to selectively couple the first downstream receiver circuitry 30, during a reception time slot, to a first part 12_1 of the reception path 12 or a first part 12_1 of the reception path 32.

The apparatus 10 is configured to separately control frequency offsets applied to the first part 12_1 of a reception path 12, 32; applied to a second part 12_2 of a reception path 12, 32 and applied to the first feedback path 132 before processing via the respective downstream receiver circuitry 30, 30_1, 30_2.

A received signal 11 is split by splitter 60_1 into two along a path 12_2 via a low-noise amplifier 14 and a frequency shift circuitry 62_2 (mixer) to be processed at downstream receiver circuitry 30_1, 30_2, and along a path 12_1 via a low-noise amplifier 14 and a frequency shift circuitry 62_1 (mixer) to the switching arrangement 40 which controls whether or not the switched signal is processed at downstream receiver circuitry 30.

The apparatus 10 therefore comprises multiple reception paths 12, 32 including the first reception path 12 and a second reception path 32. The switch arrangement 40 is configured to couple the first downstream receiver circuitry 30, during a reception time slot, to the any one of the multiple reception paths 12, 32 and configured to couple the first downstream receiver circuitry 30, during a transmission time slot, to the first feedback path 132.

The shared concept of the feedback path 132 may easily be extended to any receive port of the transceiver that has TDD support, and then controlled through a switch allowing one of the paths to utilize the feedback path 132 either for irregular bandwidth support or for improved filtration of each component carrier in non-contiguous intra-band carrier aggregation. An apparatus 10 can comprise more than one feedback path. The re-use of the feedback path 132 may apply as well on diversity reception paths.

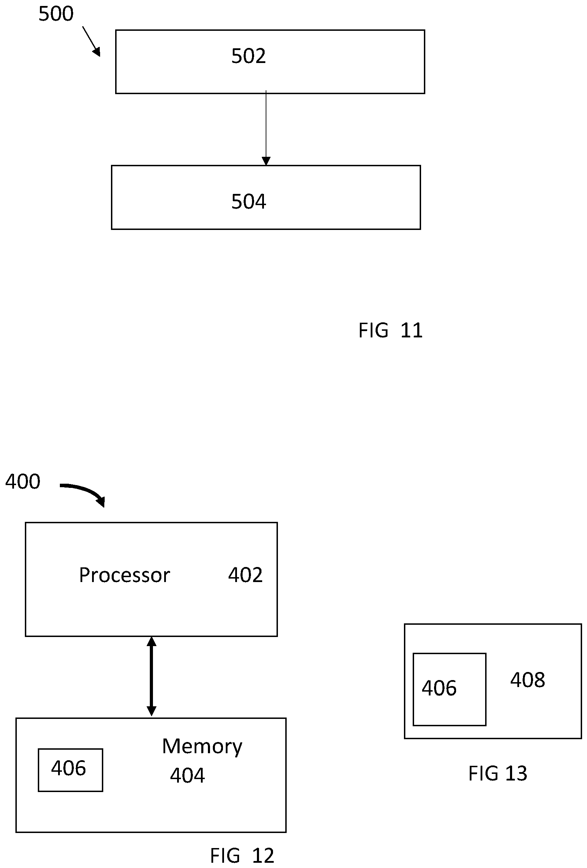

FIG 11 illustrates an example of a method 500. The method 500 shares first downstream receiver circuitry 30 between a first reception path 12 and a first feedback path 132.

For example, in the reception time slot it can be used to receive a signal for demodulation, and in some examples the signal is a frequency limited portion of a signal and in some examples the signal is associated with a component carrier used for carrier aggregation.

At block 502, the method 500 comprises during a transmission time slot, coupling a first feedback path 132 to a first downstream receiver circuitry 30.

At block 504, the method 500 comprises during a reception time slot, coupling a first reception path 12 to the first downstream receiver circuitry 30.

In some examples, at block 502, the method 500 comprises detection that a timing corresponds to a transmission time slot, and in response to that detection coupling a first feedback path 132 to a first downstream receiver circuitry 30.

In some examples, at block 504, the method 500 comprises detection that a timing corresponds to a reception time slot, and in response to that detection coupling a a first reception path 12 to the first downstream receiver circuitry 30.

In at least some examples, the first downstream receiver circuitry 30 comprises analogue baseband circuitry that includes analogue filtration circuitry. This analogue baseband circuitry 30 can be re-used, for different applications, in the transmission time slots and the reception time slots. For example, in the transmission time slot it can be used to control digital pre-distortion during a transmission time slot.

Fig 12 illustrates an example of a controller 400 suitable for use in an apparatus 10. Implementation of a controller 400 may be as controller circuitry. The controller 400 may be implemented in hardware alone, have certain aspects in software including firmware alone or can be a combination of hardware and software (including firmware).

As illustrated in Fig 12 the controller 400 may be implemented using instructions that enable hardware functionality, for example, by using executable instructions of a computer program 406 in a general-purpose or special-purpose processor 402 that may be stored on a computer readable storage medium (disk, memory etc.) to be executed by such a processor 402.

The processor 402 is configured to read from and write to the memory 404. The processor 402 may also comprise an output interface via which data and/or commands are output by the processor 402 and an input interface via which data and/or commands are input to the processor 402.

The memory 404 stores a computer program 406 comprising computer program instructions (computer program code) that controls the operation of the apparatus 10 when loaded into the processor 402. The computer program instructions, of the computer program 406, provide the logic and routines that enables the apparatus to perform the methods illustrated in the accompanying Figs. The processor 402 by reading the memory 404 is able to load and execute the computer program 406.

The apparatus 10 comprises:
at least one processor 402; and
at least one memory 404 including computer program code
the at least one memory 404 and the computer program code configured to, with the at least one processor 402, cause the apparatus 10 at least to perform:
   during a transmission time slot, couple a first feedback path 132 to a first downstream receiver circuitry 30; and
   during a reception time slot, couple a first reception path 12 to the first downstream receiver circuitry 30.

The apparatus 10 comprises:
at least one processor 402; and
at least one memory 404 including computer program code,
the at least one memory storing instructions that, when executed by the at least one processor 402, cause the apparatus at least to:
   during a transmission time slot, couple a first feedback path 132 to a first downstream receiver circuitry 30; and during a reception time slot, couple a first reception path 12 to the first downstream receiver circuitry 30.

As illustrated in Fig 13, the computer program 406 may arrive at the apparatus 10 via any suitable delivery mechanism 408. The delivery mechanism 408 may be, for example, a machine-readable medium, a computer-readable medium, a non-transitory computer-readable storage medium, a computer program product, a memory device, a record medium such as a Compact Disc Read-Only Memory (CD-ROM) or a Digital Versatile Disc (DVD) or a solid-state memory, an article of manufacture that comprises or tangibly embodies the computer program 406. The delivery mechanism may be a signal configured to reliably transfer the computer program 406. The apparatus 10 may propagate or transmit the computer program 406 as a computer data signal.

Computer program instructions for causing an apparatus to perform at least the following or for performing at least the following:
causing a switching arrangement 40 to split a reception path associated with a received bandwidth 19 into a plurality of reception paths associated with overlapping bandwidths 19_1, 19_2 and enable processing each of the plurality of reception paths via different downstream receiver circuitry 30_1, 30_2.

The computer program instructions may be comprised in a computer program, a non-transitory computer readable medium, a computer program product, a machine-readable medium. In some but not necessarily all examples, the computer program instructions may be distributed over more than one computer program.

Although the memory 404 is illustrated as a single component/circuitry it may be implemented as one or more separate components/circuitry some or all of which may be integrated/removable and/or may provide permanent/semi-permanent/ dynamic/cached storage.

Although the processor 402 is illustrated as a single component/circuitry it may be implemented as one or more separate components/circuitry some or all of which may be integrated/removable. The processor 402 may be a single core or multi-core processor.

References to 'computer-readable storage medium', 'computer program product', 'tangibly embodied computer program' etc. or a 'controller', 'computer', 'processor' etc. should be understood to encompass not only computers having different architectures such as single /multi- processor architectures and sequential (Von Neumann)/parallel architectures but also specialized circuits such as field-programmable gate arrays (FPGA), application specific circuits (ASIC), signal processing devices and other processing circuitry. References to computer program, instructions, code etc. should be understood to encompass software for a programmable processor or firmware such as, for example, the programmable content of a hardware device whether instructions for a processor, or configuration settings for a fixed-function device, gate array or programmable logic device etc.

As used in this application, the term 'circuitry' may refer to one or more or all of the following:
(a) hardware-only circuitry implementations (such as implementations in only analog and/or digital circuitry) and
(b) combinations of hardware circuits and software, such as (as applicable):
   (I) a combination of analog and/or digital hardware circuit(s) with software/firmware and
   (ii) any portions of hardware processor(s) with software (including digital signal processor(s)), software, and memory or memories that work together to cause an apparatus, such as a mobile phone or server, to perform various functions and
(c) hardware circuit(s) and or processor(s), such as a microprocessor(s) or a portion of a microprocessor(s), that requires software (for example, firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the particular claim element, a baseband integrated circuit for a mobile device or a similar integrated circuit in a server, a cellular network device, or other computing or network device.

The blocks illustrated in the accompanying Figs may represent steps in a method and/or sections of code in the computer program 406. The illustration of a particular order to the blocks does not necessarily imply that there is a required or preferred order for the blocks and the order and arrangement of the block may be varied. Furthermore, it may be possible for some blocks to be omitted.

Where a structural feature has been described, it may be replaced by means for performing one or more of the functions of the structural feature whether that function or those functions are explicitly or implicitly described.

As used here 'module' refers to a unit or apparatus that excludes certain parts/components that would be added by an end manufacturer or a user. The apparatus 10 can be a module.

The apparatus 10 can be a user equipment. The user equipment can be a mobile telephone, cellular telephone, Internet of Things device etc.

The apparatus 10 can be any suitable device, apparatus or system. In at least some examples, the apparatus 10 is a hand-portable apparatus. A hand-portable apparatus is an apparatus than can be used while held in one hand and operated by another hand. In at least some examples, the hand-portable apparatus has a mass less than 0.5 kg. In at least some examples, the apparatus 10 is additionally a pocket-portable apparatus. A pocket-portable apparatus is an apparatus than can fit into a pocket in clothing. In at least some examples, the pocket-portable apparatus has a length less than 20cm, a width less than 10cm and a depth less than 3 cm.

The above-described examples find application as enabling components of: automotive systems; telecommunication systems; electronic systems including consumer electronic products; distributed computing systems; media systems for generating or rendering media content including audio, visual and audio visual content and mixed, mediated, virtual and/or augmented reality; personal systems including personal health systems or personal fitness systems; navigation systems; user interfaces also known as human machine interfaces; networks including cellular, non-cellular, and optical networks; ad-hoc networks; the internet; the internet of things; virtualized networks; and related software and services.

The apparatus can be provided in an electronic device, for example, a mobile terminal, according to an example of the present disclosure. It should be understood, however, that a mobile terminal is merely illustrative of an electronic device that would benefit from examples of implementations of the present disclosure and, therefore, should not be taken to limit the scope of the present disclosure to the same. While in certain implementation examples, the apparatus can be provided in a mobile terminal, other types of electronic devices, such as, but not limited to: mobile communication devices, hand portable electronic devices, wearable computing devices, portable digital assistants (PDAs), pagers, mobile computers, desktop computers, televisions, gaming devices, laptop computers, cameras, video recorders, GPS devices and other types of electronic systems, can readily employ examples of the present disclosure. Furthermore, devices can readily employ examples of the present disclosure regardless of their intent to provide mobility.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, the wording 'connects', 'couple' and 'communication' and their derivatives mean operationally connected/coupled/in communication. It should be appreciated that any number or combination of intervening components can exist (including no intervening components), i.e., so as to provide direct or indirect connection/coupling/communication. Any such intervening components can include hardware and/or software components.

As used herein, the term "determine/determining" (and grammatical variants thereof) can include, not least: calculating, computing, processing, deriving, measuring, investigating, identifying, looking up (for example, looking up in a table, a database or another data structure), ascertaining and the like. Also, "determining" can include receiving (for example, receiving information), accessing (for example, accessing data in a memory), obtaining and the like. Also, " determine/determining" can include resolving, selecting, choosing, establishing, and the like.

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a', 'an' or 'the' is used in this document with an inclusive not an exclusive meaning. That is any reference to X comprising a/an/the Y indicates that X may comprise only one Y or may comprise more than one Y unless the context clearly indicates the contrary. If it is intended to use 'a', 'an' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description. Nonetheless, the above description should be read as implicitly including reference to such alternative structures and method features which provide equivalent functionality unless such alternative structures or method features are explicitly excluded in the above description of the examples of the present disclosure.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. An apparatus comprising:
a first reception path comprising a first low noise amplifier;
a first feedback path comprising a second low noise amplifier;
first downstream receiver circuitry;
a switching arrangement configured to, in a first state, couple the first reception path to the first downstream receiver circuitry and configured to, in a second state, couple the first feedback path to the first downstream receiver circuitry; and
a controller configured to place the switching arrangement in the first state during a reception time slot and in the second state during a transmission time slot.

2. An apparatus as claimed in claim 1, wherein the first feedback path is configured to receive transmission signals on a transmission path, the apparatus comprising means for processing received transmission signals received via the first feedback path and first downstream receiver circuitry, during a transmission time slot, to control envelope tracking and digital pre-distortion of transmission signals transmitted via the transmission path.

3. An apparatus as claimed in any preceding claim, comprising a second downstream receiver circuitry;
the apparatus being:
configured to split the first reception path into at least a first part and a second part;
configured to couple the first downstream receiver circuitry, during a reception time slot, to a first part of the first reception path;
configured to couple the second downstream receiver circuitry, during the reception time slot, to a second part of the first reception path;
configured to couple the first downstream receiver circuitry, during the transmission time slot, to the first feedback path.

4. An apparatus as claimed in any preceding claim, comprising multiple reception paths including the first reception path and a second reception path;
wherein the switch arrangement is configured to couple the first downstream receiver circuitry, during a reception time slot, to the any one of the multiple reception paths and configured to couple the first downstream receiver circuitry, during a transmission time slot, to the first feedback path.

5. An apparatus as claimed in any preceding claim, wherein the switch arrangement is configured to have:
a state that couples the first reception path but not the first feedback path to the downstream receiver circuitry; and
a state that couples the first feedback path but not the first reception path to the downstream receiver circuitry.

6. An apparatus as claimed in claim 5, wherein the switching arrangement comprises:
a first switching circuitry configured to have a first switching state that enables coupling of the first reception path to the first downstream receiver circuitry and a second switching state that disables coupling of the first reception path to the first downstream receiver circuitry;
a second switching circuitry configured to have a first switching state that enables coupling of the first feedback path to the first downstream receiver circuitry and a second switching state that disables coupling of the first feedback path to the first downstream receiver circuitry,
wherein a switching state that couples the first reception path but not the first feedback path to the first downstream receiver circuitry comprises a first switching state of the first switching circuitry and a second switching state of the second switching circuitry; and
a switching state that couples the first feedback path but not the first reception path to the first downstream receiver circuitry comprises a second switching state of the first switching circuitry and a first switching state of the second switching circuitry.

7. An apparatus as claimed in any preceding claim, wherein the switching arrangement is configured to enable coupling of the first reception path to first downstream receiver circuitry by selectively coupling a first upstream node coupled to the first reception path and a first downstream node coupled to the first downstream receiver circuitry and disable coupling of the first reception path to the first downstream receiver circuitry by selectively decoupling the first upstream node and the first downstream node and terminating the first upstream node to ground and the first downstream node to ground.

8. An apparatus as claimed in any preceding claim, wherein the switching arrangement is configured to enable coupling of the first feedback path to first downstream receiver circuitry by selectively coupling an upstream node coupled to the first feedback path and a downstream node coupled to the first downstream receiver circuitry and disable coupling of the first feedback path to the first downstream receiver circuitry by selectively decoupling the upstream node and the downstream node and terminating the upstream node to ground and the downstream node to ground.

9. An apparatus as claimed in any preceding claim, configured to separately control frequency offsets applied to the first reception path and the first feedback path before processing via the first downstream receiver circuitry.

10. An apparatus as claimed in any preceding claim, wherein the controller is configured to place the switching arrangement in the first state to support reception of a first bandwidth, wherein the switching arrangement is configured in the first state to enable processing of the received first bandwidth as a plurality of overlapping bandwidths wherein one of the plurality of overlapping bandwidths is processed via the first downstream receiver circuitry and another one of the plurality of overlapping bandwidths is processed via a second downstream receiver circuitry,
and/or wherein the controller is configured to place the switching arrangement in the first state to support carrier aggregation, wherein the switching arrangement is configured in the first state to enable processing of a first component carrier by the first downstream receiver circuitry and processing of a second component carrier by a second downstream receiver circuitry.

11. An apparatus as claimed in any preceding claim, wherein the controller is configured to determine a state of the switching arrangement, during a reception time slot, in dependence upon any one or more of:
network configuration as regards non-contiguous intra-band carrier aggregation;
network configured irregular bandwidth;
availability of downstream receiver circuitry;
interference, if any, in frequencies adjacent the received first bandwidth.

12. An apparatus as claimed in any preceding claim, wherein the controller is configured to:
update capability information provided to a network in dependence upon availability of downstream receiver circuitry.

13. A method comprising:
during a transmission time slot, couple a first feedback path to a first downstream receiver circuitry; and
during a reception time slot, couple a first reception path to the first downstream receiver circuitry.

14. A computer program comprising instructions that when run by one or more processors causes a switching arrangement to:
during a transmission time slot, couple a first feedback path to a first downstream receiver circuitry; and
during a reception time slot, couple a first reception path to the first downstream receiver circuitry.

15. User equipment comprising the apparatus of any of claims 1 to 13.
